# EUROPEAN PATENT SPECIFICATION

(11) **EP 2 919 326 B1**
(45) Date of publication and mention of the grant of the patent: **22.02.2017**
(21) Application number: 14158703.0
(22) Date of filing: 11.03.2014
(51) Int. Cl.: H05K 1/14, H05K 3/40, H05K 3/36, H01R 24/64, H01R 13/6469, H01R 13/6467, H01R 13/6466, H01R 12/52

(54) **Connector and assembly method for transmission assembly of connector**
Verbinder und Montageverfahren für die Übertragungsanordnung eines Verbinders
Connecteur et procédé d'assemblage pour ensemble de transmission de connecteur

(43) Date of publication of application: 16.09.2015
(73) Proprietor: Telebox Industries Corp., 22146 Hsichih-Taipei (TW)
(72) Inventor: Wu, Fu-Wen, Keelung City (TW); Huang, Su-Hui, Keelung City (TW); Hsu, Ching-Yi, New Taipei City (TW)
(74) Representative: Lang, Christian

(56) References cited:
- EP-A1- 2 487 761
- US-A- 5 857 858
- US-A1- 2005 189 566
- US-A1- 2010 151 707
- US-B1- 7 040 927
- US-B1- 8 052 482
- US-B1- 8 496 500

## Description

### Technical Field

The disclosure relates to a connector, more particularly to a connector with an expanded circuit board and an assembly method for a transmission assembly of a connector.

### Background

The related industries have been improving the high-speed transmission of telecommunication signals for providing internet users a better network environment. Nowadays the transmission speed of a C6A RJ45 connector is 500MHz. However, as the transmission speed increases, the impacts of crosstalk grow. This worsens the transmission quality of the RJ45 connector. In other words, crosstalk is obstacle to improve the transmission speed of the RJ45 connector.

Since today's transmission speed of the RJ45 connector is much faster than the speed of 250MHz in the early RJ45 connector, sorting terminals and changing locations are no longer effective in terms of restraining crosstalk. Hence, the designers need to utilize noise-suppression components, such as resistance or capacitance, to improve the suppression of crosstalk. Nevertheless, the space of the circuit board inside the RJ45 connector is limited, so the space is insufficient to dispose a circuit for the suppression of crosstalk. Therefore, it is important to arrange a space in the RJ45 connector for disposing the circuit, so that the circuit for the suppression of crosstalk can be disposed thereon in order to reduce the impact of crosstalk.

EP 2 487 761 A1 discloses a telecommunications jack for making electrical connection to a mating plug. The telecommunications jack comprises a first supporting printed circuit board holding an array of front contacts, and a second printed circuit board onto which the front contacts extend in order to provide for advantageous mechanical properties.

### SUMMARY

A connector comprises an insulated housing having a slot and a transmission assembly located inside the insulated housing. The transmission assembly comprises a main circuit board, an expanded circuit board, a plurality of first terminals and at least one second terminal. The expanded circuit board is stacked on the surface of the main circuit board and a first lateral side and a second lateral side of the expanded circuit board which are opposite to each other has a plurality of first electrical contacts and at least one second electrical contact, respectively. The first terminals and the at least one second terminal are plugged in the main circuit board. One ends of the first terminals are in electrical contact with the first electrical contacts respectively. The other ends of the first terminals bend and extend towards the second lateral side of the expanded circuit board. One end of the at least one second terminal is in electrical contact with the at least one second electrical contact. The other end of the second terminal bends and extends towards the first lateral side of the expanded circuit board, while the other end of the second terminal is pressed against one side of the expanded circuit board away from the main circuit board, thereby fixing the expanded circuit board to the main circuit board and making the expanded circuit board and the main circuit board be electrically connected to each other. The sum of the numbers of the first electrical contacts and the number of the at least one second electrical contact is eight, the sum of the number of the first terminals and the number of the at least one second terminal is eight, the first lateral side of the expanded circuit board has at least one first recess portion, the second lateral side has at least one second recess portion, each first electrical contact is formed on one at least one first recess portion, and each second electrical contact is formed on one at least one second recess portion.

An assembly method for a transmission assembly of a connector comprises steps of: plugging a plurality of first terminals in a main circuit board; plugging at least one second terminal in the main circuit board; disposing an expanded circuit board on the main circuit board, wherein a first lateral side and a second lateral side of the expanded circuit board which are opposite to each other have a plurality of first electrical contacts and at least one second electrical contact, respectively, and the expanded circuit board is disposed between the first terminals and the second terminal, the first lateral side of the expanded circuit board has at least one first recess portion, the second lateral side has at least one second recess portion, the first electrical contacts are formed on the at least one first recess portion, and the second electrical contacts are formed on the at least one second recess portion; bending the first terminals so that the first terminals each forms a first limit section and a first contact section, wherein the first limit sections are in electrical contact with the first electrical contacts, respectively, and the first contact sections extend towards the second lateral side; and bending the second terminal so that it forms a second limit section and a second contact section, wherein the second limit section is in electrical contact with the second electrical contact, while the second contact section extends towards the first lateral side and is pressed against one side of the expanded circuit board away from the main circuit board.

### BRIEF DESCRIPTION OF THE DRAWINGS

The present disclosure will become more fully understood from the detailed description given hereinbelow, along with the accompanying drawings which are for illustration only, thus are not limitative of the present disclosure, and wherein:
FIG. 1 is a perspective view of a connector according to the first embodiment of the disclosure;
FIG. 2 is an exploded view of FIG. 1;
FIG. 3 is an exploded view of the transmission assembly of FIG. 2;
FIG. 4 is a schematic view of the assembly of FIG. 3;
FIG. 5A is a partial top view of the transmission assembly of FIG. 4;
FIG. 5B is a partial top view of the transmission assembly according to the second embodiment of the disclosure;
FIG. 5C is a partial top view of the transmission assembly according to the third embodiment of the disclosure;
FIG. 5D is a partial top view of the transmission assembly according to the fourth embodiment of the disclosure; and
FIG. 6A to FIG. 6E are schematic side views of the assembly process of the transmission assembly of FIG. 4.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

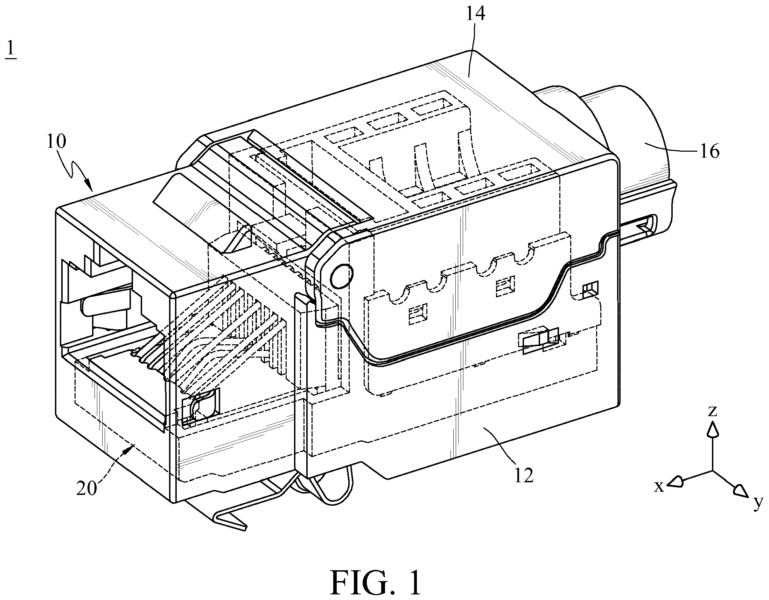

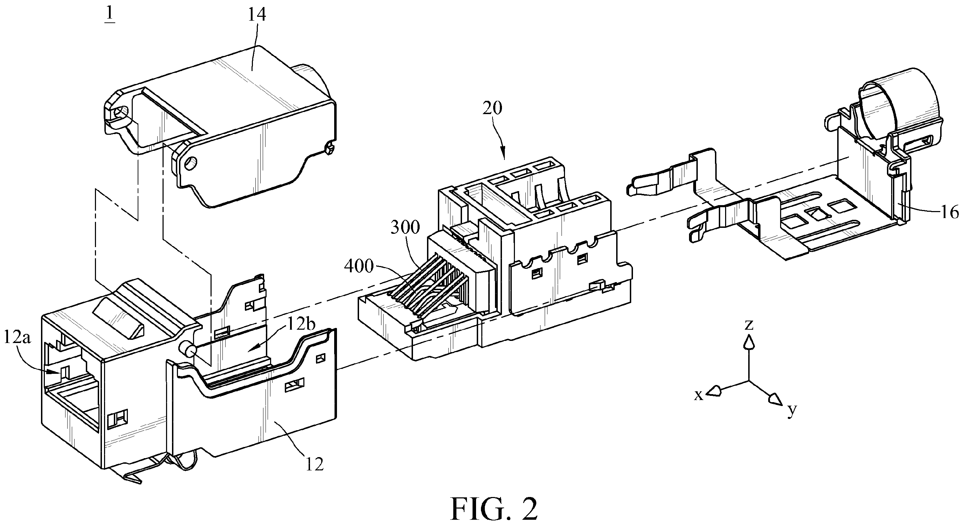

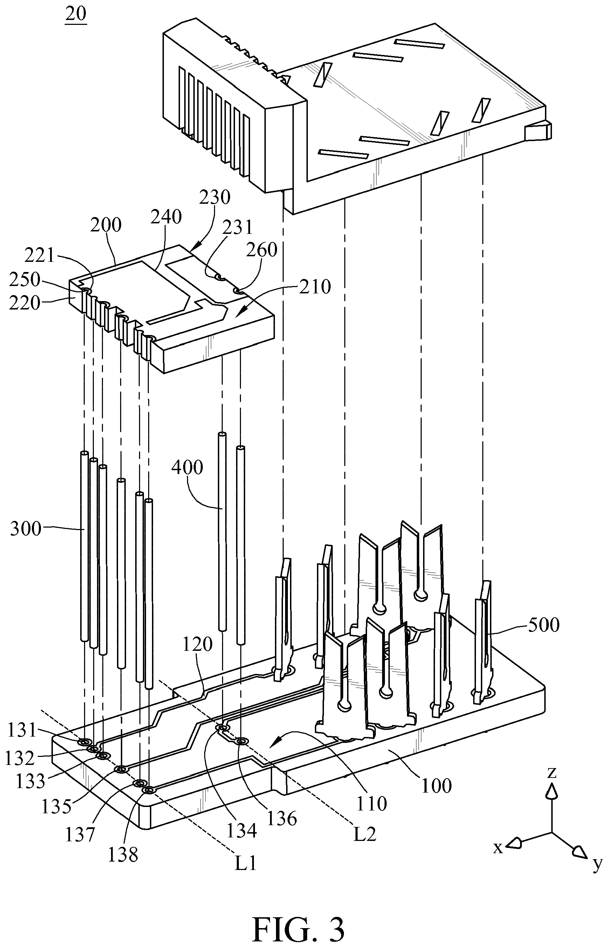

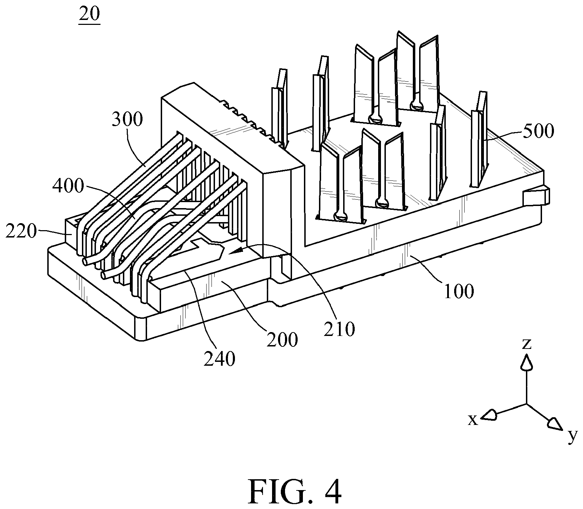

FIG. 1 is a perspective view of a connector according to the first embodiment of the disclosure; FIG. 2 is an exploded view of FIG. 1; FIG. 3 is an exploded view of the transmission assembly of FIG. 2; FIG. 4 is a schematic view of the assembly of FIG. 3. As seen in FIG. 1 to FIG. 4, in this embodiment, a connector 1 (e.g. A RJ45 connector) comprises an insulated housing 10 and a transmission assembly 20. The insulated housing 10 comprises a main body 12, a top cover 14 and a back cover 16. The main body 12 has a slot 12a and an accommodating notch 12b. The slot 12a is configured for being plugged in by another connector (not shown in the figures). The accommodating notch 12b connects to the slot 12a, and the transmission assembly 20 is located in the accommodating notch 12b. The top cover 14 is installed on the main body 12 and covers the transmission assembly 20. A back cover 16 is installed on the main body 12 while the back cover 16 and the main body 12 abut on two opposite sides of the main circuit board 100.

The transmission assembly 20 comprises a main circuit board 100, an expanded circuit board 200, a plurality of the first terminal 300, at least one the second terminal 400 and a plurality of the piercing terminals 500.

The main circuit board 100 has a surface 110 and a transmission circuit 120 located on the surface 110.

The expanded circuit board 200 is stacked on the surface 110 and has a top surface 210, a first lateral side 220, a second lateral side 230, an expanded circuit 240, a plurality of the first electrical contact 250, two second electrical contacts 260 and a transmission circuit 120. The first lateral side 220 and the second lateral side 230 are connected to opposite two sides of the top surface 210, respectively. The first lateral side 220 has a plurality of the first recessed portions 221, while the second lateral side 230 has two second recessed portions 231.
The expanded circuit 240 is disposed on the top surface 210. The expanded circuit 240 is, for example, a noise suppression circuit.

The first electrical contact 250 and the second electrical contact 260 are, for example, metal films and are electrically connected to the expanded circuit 240 respectively. These first electrical contacts 250 are formed on the wall surface of these first recessed portions 221. The two first electrical contacts 250 are formed on the wall surface of the two first recessed portions 221, respectively. The two second electrical contacts 260 are formed on the wall surface of the two second recessed portions 231, respectively. In this embodiment, the number of the first electrical contacts 250 is six, while the number of the second electrical contacts 260 is two, but the disclosure is not limited thereto. In other embodiments, the numbers of the first electrical contacts 250 and the second electrical contacts 260 can be any numbers as long as the sum of them is eight.

In this embodiment, the number of the first terminals 300 is six and these first terminals 300 are arranged along a first line L1. Each first terminal 300 bends and forms a first limit section 310 and a first contact section 320. One end of the first limit section 310 is plugged in the main circuit board 100, while the other end is in electrical contact with the first electrical contact 250, for expanding the freedom of movement of the expanded circuit board 200 along a horizontal direction (namely positive x-axis direction). These first contact sections 320 extend from the first limit section 310 towards the second lateral side 230, and an obtuse angle is formed between the first contact section 320 and the first limit section 310.

The number of the second terminals 400 is two and theses two second terminals 400 are arranged along a second line L2 parallel to the first line L1. Each second terminal 400 bends and forms a second limit section 410 and a second contact section 420. One end of the second limit section 410 is plugged in the main circuit board 100, while the other end is in electrical contact with the second electrical contact 260, for expanding the freedom of movement of the expanded circuit board 200 along another horizontal direction (namely negative x-axis direction). These second contact sections 420 bend and extend from the second limit section 410 towards the first lateral side 220 and is pressed against the top surface 210 of the expanded circuit board 200 for limiting the freedom of movement of the expanded circuit board 200 along a vertical direction (namely z-axis direction)

In this embodiment, the first contact section 320 and the second contact section 420 are exposed from the slot 12a and are in electrical contact with another connector (not shown in the figures). To prevent them from hindering connection, the height of the end of the second contact section 420 away from the first limit section 310 is designed to be lower than the top surface 210 of the expanded circuit board 200.

Moreover, each first electrical contact 250 is formed on each first recessed portion 221 while each second electrical contact 260 is formed on each second recessed portion 231. When each first terminal 300 is in electrical contact with each first electrical contact 250, the first terminal 300 is also fastened with each first recessed portion 221. Additionally, when the two second terminals 400 are in electrical contact with the two second electrical contacts 260, the two second terminals 400 are also fastened with the two second recessed portions 231, thereby limiting the freedom of movement of the expanded circuit board 200 along another horizontal direction (namely negative y-axis direction).

In this embodiment, the number of the first terminals 300 is six while the number of the second terminals 400 is two, but they are not limited thereto. In other embodiments, the numbers of the first terminal 300 and the second terminal 400 can be any numbers as long as the sum of them is eight.

The plurality of the piercing terminal 500 is plugged in the main circuit board 100, and is electrically connected to each first terminal 300 and the two second terminals 400 respectively, via the transmission circuit 120. These piercing terminals 500 are used for being plugged by a transmission cable (not shown). When the transmission cable is plugged in the piercing terminal 500, the piercing terminal 500 pierces the insulation surface of the transmission cable for direct electrical connection with the conductive circuit on the outer part of the transmission cable.

According to the above-mentioned structure, fixing and electrical connection can be achieved via the first limit section 310 of each first terminal 300, the first contact section 320, the second limit section 410 of each second terminal 400 and the second contact section 420. Thereby, the welding process is not required in the assembly process so that the efficiency of the assembly of the connector 1 is improved.

Furthermore, electrically connecting the expanded circuit 240 with the transmission circuit 120 via each first terminal 300 and each second terminal 400 can limit crosstalk interference and electromagnetic interference while the transmission circuit 120 is transmitting the signal.

Additionally, when being plugged into or being separated from another connector, since the expanded circuit board 200 is fixed to the main circuit board 100 by each first terminal 300 and each second terminal 400, the expanded circuit board 200 does not swing with each first terminal 300 and each second terminal 400, thereby not increasing the possibility of the disconnection between the expanded circuit board 200 and each first terminal 300 as well as each second terminal 400. In contrast, this enhances the reliability of the connection structure between the main circuit board 100 and the expanded circuit board 200 when another connector is plugged in.

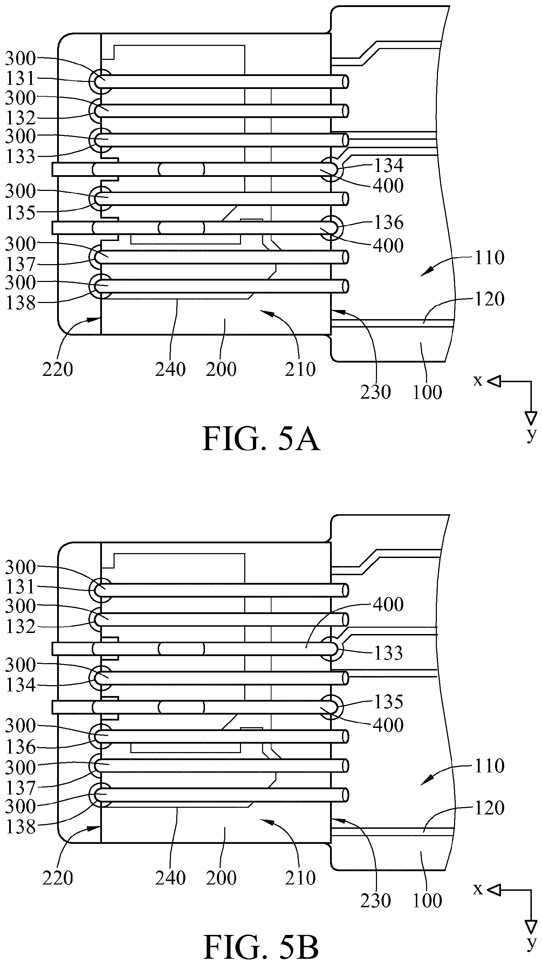

Now a further design of the arrangement of the first terminal 300 and the second terminal 400 for limiting the crosstalk interference will be illustrated. FIG. 5A is a partial top view of the transmission assembly of FIG. 4. As seen in FIG. 5A, in this embodiment, the total number of the first terminals 300 and the second terminal 400 is eight. The main circuit board 100 has a first socket 131 to an eighth socket 138 along the positive y-axis direction. Six first terminal 300 are plugged in the first socket 131, the second socket 132, the third socket 133, the fifth socket 135, the seventh socket 137 and the eighth socket 138 respectively, while two second terminals 400 are plugged in the fourth socket 134 and the sixth socket 136 respectively. That is, in this embodiment, one of the first terminals 300 is between the two second terminals 400, but the disclosure is not limited thereto.

FIG. 5B is a partial top view of the transmission assembly according to the second embodiment of the disclosure. As seen in FIG. 5B, in this embodiment, the total number of the first terminals 300 and the second terminal 400 is eight. The main circuit board 100 has a first socket 131 to an eighth socket 138 along the positive y-axis direction. Six first terminals 300 are plugged in the first socket 131, the second socket 132, the fourth socket 134, the sixth socket 136, the seventh socket 137 and the eighth socket 138 respectively, while two second terminals 400 are plugged in the third socket 133 and the fifth socket 135 respectively. Similarly, in this embodiment, one of the first terminals 300 is between the two second terminals 400.

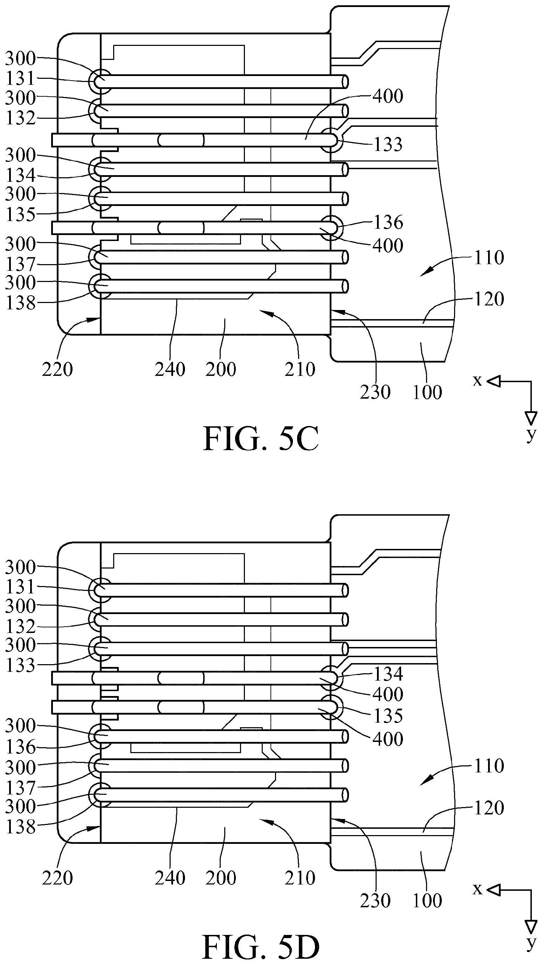

FIG. 5C is a partial top view of the transmission assembly according to the third embodiment of the disclosure. As seen in FIG. 5C, in this embodiment, the total number of the first terminals 300 and the second terminal 400 is eight. The main circuit board 100 has a first socket 131 to an eighth socket 138 along the positive y-axis direction. Six first terminals 300 are plugged in the first socket 131, the second socket 132, the fourth socket 134, the fifth socket 135, the seventh socket 137 and the eighth socket 138 respectively, while two second terminals 400 are plugged in the third socket 133 and the sixth socket 136 respectively. Similarly, in this embodiment, two of the first terminals 300 are between the two second terminals 400.

FIG. 5D is a partial top view of the transmission assembly according to the fourth embodiment of the disclosure. As seen in FIG. 5D, in this embodiment, the total number of the first terminals 300 and the second terminals 400 is eight. The main circuit board 100 has a first socket 131 to an eighth socket 138 along the positive y-axis direction. Six first terminals 300 are plugged in the first socket 131, the second socket 132, the third socket 133, the sixth socket 136, the seventh socket 137 and the eighth socket 138 respectively, while two second terminals 400 are plugged in the fourth socket 134 and the fifth socket 135 respectively. Similarly, in this embodiment, the two second terminals 400 are adjacent to each other.

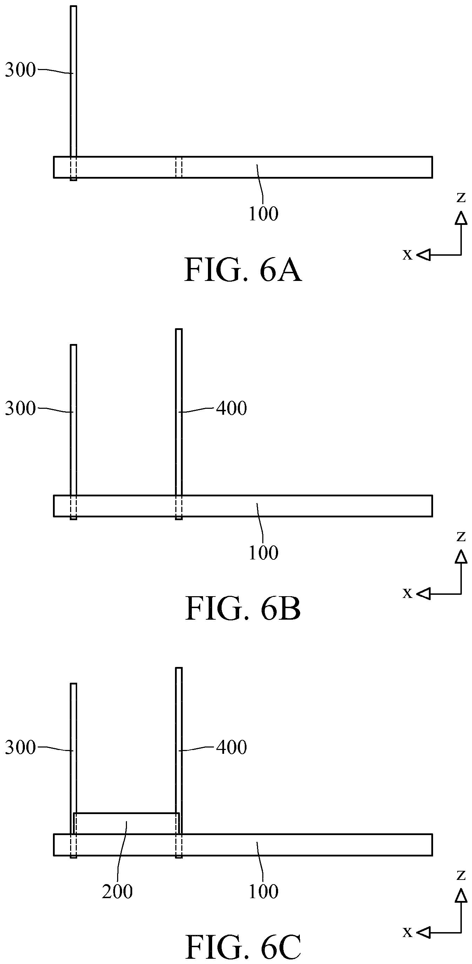

Now the assembly method of the connector 1 and the transmission assembly 20 will be illustrated for clarifying how convenient the assembly is. Referring to FIG. 6A to FIG. 6E, FIG. 6A to FIG. 6E are schematic side views of the assembly process of the transmission assembly of FIG. 4.

As seen in FIG. 6A, six first terminals 300 are plugged in the main circuit board 100.

As seen in FIG. 6B, two second terminals 400 are plugged in the main circuit board 100.

As seen in FIG. 6C, each first recessed portion 221 and each second recessed portion 231 of the expanded circuit board 200 slide along extending paths of each first terminal 300 and two second terminals 400 to stack on the main circuit board 100 of the expanded circuit board 200, while the expanded circuit board 200 is disposed between these first terminals 300 and the two second terminals 400.

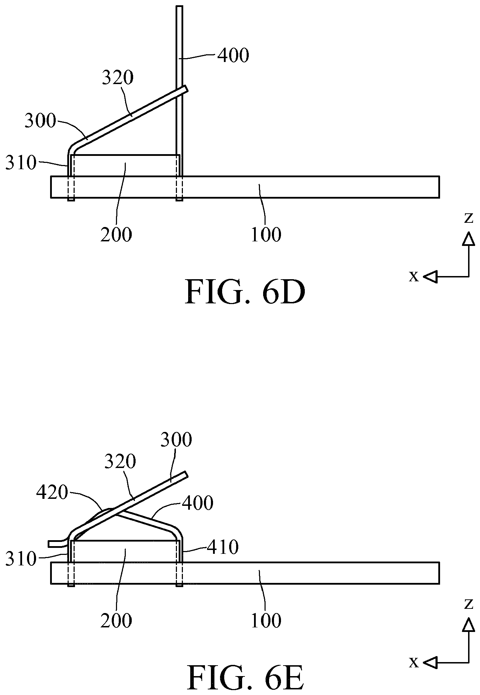

As seen in FIG. 6D, these first terminals 300 are bent for making each of them form a first limit section 310 and a first contact section 320. These first limit sections 310 are in electrical contact with the first electrical contacts 250 of the expanded circuit board 200 respectively, and the first contact sections 320 extend towards the second lateral side 230.

As seen in FIG. 6E, two second terminals 400 are bent for making each of them form a second limit section 410 and a second contact section 420. The two second limit sections 410 are in electrical contact with the second electrical contact 260 respectively. The second contact section 420 extends towards the first lateral side 220 and is pressed against one side of the expanded circuit board 200 away from the main circuit board 100, thereby completing the assembly of the transmission assembly 20.

However, bending the first terminal 300 before bending the second terminal 400 is not intended to limit the disclosure. In one embodiment, it is possible that the first terminal 300 is bent after the second terminal 400 is bent.

In the connector illustrated above, the expanded circuit board is directly fixed to and electrically connected to the main circuit board via the first terminal and the second terminal. Thus, the welding process is not required in the assembly process so that the efficiency of the assembly of the connector is improved.

Furthermore, the expanded circuit board can be a support plate for the first terminal and the second terminal while being disposed between them.

Additionally, plugging another connector into this connector or separating another connector from this connector may enhance the connection structure of the main circuit board and the expanded circuit board.

## Claims

1. A connector (1) comprising:
an insulated housing (10) having a slot (12a); and a transmission assembly (20) located inside the insulated housing (10), wherein the transmission assembly (20) comprises a main circuit board (100), an expanded circuit board (200), a plurality of first terminals (300) and at least one second terminal (400), the expanded circuit board (200) has a top surface (210), a first lateral side (220) and a second lateral side (230), wherein the expanded circuit board (200) is disposed on the main circuit board (100), and the first lateral side (220) and the second lateral side (230) of the expanded circuit board (200) which are opposite to each other have a plurality of first electrical contacts (250) and at least one second electrical contact (260), respectively, and the first terminals (300) and the at least one second terminal (400) are plugged in the main circuit board (100), wherein the first terminals (300) bend and form a first limit section (310) and a first contact section (320), the at least one second terminal (400) bends and forms a second limit section (410) and a second contact section (420), one end of each first limit section (310) and one end of the second limit section (410) are plugged in the main circuit board (100), while the expanded circuit board (200) is disposed between the other ends of the first limit section (310) and the other end of the second limit section (410) which are in electrical contact with the first electrical contacts (250) and the second electrical contact (260), respectively, and wherein at least a part of the second contact section (420) extends towards the first lateral side of the expanded circuit board and is pressed against the top surface (210) of the expanded circuit board (200), thereby fixing the expanded circuit board (200) to the main circuit board (100) and making the expanded circuit board (200) and the main circuit board (100) be electrically connected to each other, wherein the sum of the numbers of the first electrical contacts (250) and the number of the at least one second electrical contact (260) is eight, the sum of the number of the first terminals (300) and the number of the at least one second terminal (400) is eight, the first lateral side (220) of the expanded circuit board (200) has at least one first recess portion (221), the second lateral side (230) has at least one second recess portion (231), each first electrical contact (250) is formed on one at least one first recess portion (221), and each second electrical contact (260) is formed on one at least one second recess portion (231).

2. The connector according to claim 1, wherein the number of the first electrical contacts (250) is six, the number of the at least one second electrical contacts (260) is two, the number of the first terminals (300) is six, the number of the at least one second terminals (400) is two, the first terminals (300) are arranged in a first line, the two second terminals (400) are arranged in a second line, and the first line and the second line are parallel to each other.

3. The connector (1) according to claim 2, wherein the two second terminals (400) are adjacent to each other.

4. The connector (1) according to claim 2, wherein one of the first terminals (300) is between the two second terminals (400).

5. The connector (1) according to claim 2, wherein two of the first terminals (300) are between the two second terminals (400).

6. The connector (1) according to claim 1, wherein the main circuit board (100) has a surface (110) and a transmission circuit (120), the expanded circuit board (200) is disposed on the surface (110), the expanded circuit board (200) has an expanded circuit (240), the transmission circuit (120) is electrically connected to the expanded circuit (240) via the first terminals (300), the at least one second terminal (400), the first electrical contacts (250) and the second electrical contact (260).

7. The connector (1) according to claim 6, wherein the transmission assembly (20) further comprises a plurality of piercing terminals (500), and the piercing terminals (500) are plugged in the main circuit board (100) and are electrically connected to the transmission circuit (120).

8. The connector (1) according to claim 1, wherein the insulated housing (10) comprises:
a main body (12) has an accommodating notch (12b), the slot (12a) connects the accommodating notch (12b) while the transmission assembly (20) is located in the accommodating notch (12b), and the slot (12a) exposes the first terminals (300) and the second terminal (400);
a top cover (14) installed on the main body (12) and covering the transmission assembly (20);
and a back cover (16) installed on the main body (12) while the back cover (16) and the main body (12) together abut on opposite two sides of the main circuit board (100).

9. An assembly method for a transmission assembly (20) of a connector (1), comprising steps of:
plugging a plurality of first terminals (300) in a main circuit board (100);
plugging at least one second terminal (400) in the main circuit board (100);
**characterized by**:
disposing an expanded circuit board (200) on the main circuit board (100), wherein a first lateral side (220) and a second lateral side (230) of the expanded circuit board (200) which are opposite to each other have a plurality of first electrical contacts (250) and at least one second electrical contact (260), respectively, the expanded circuit board (200) is disposed between the first terminals (300) and the second terminal (400), the first lateral side (220) of the expanded circuit board (200) has at least one first recess portion (221), the second lateral side (230) has at least one second recess portion (231), the first electrical contacts (250) are formed on the at least one first recess portion (221), and the second electrical contacts (260) are formed on the at least one second recess portion (231);
bending the first terminals (300) so that the first terminals (300) each form a first limit section (310) and a first contact section (320), wherein the first limit sections (310) are in electrical contact with the first electrical contacts (250), respectively, and the first contact sections (320) extend towards the second lateral side (230); and
bending the second terminal (400) so that it forms a second limit section (410) and a second contact section (420), wherein the second limit section (410) is in electrical contact with the second electrical contact (260), while the second contact section (420) extends towards the first lateral side (220) and is pressed against one side of the expanded circuit board (200) away from the main circuit board (100).

## Patentansprüche

1. Verbinder (1) umfassend
ein Isoliergehäuse (10) mit einem Schlitz (12a) und
eine Übertragungsanordnung (20), die innerhalb des Isoliergehäuses (10) gangeordnet ist, wobei die Übertragungsanordnung (20) eine Hauptleiterplatte (100), eine erweiterte Leiterplatte (200), eine Vielzahl von ersten Anschlüssen (300) und mindestens einen zweiten Anschluss (400) umfasst, wobei die erweiterte Leiterplatte (200) eine obere Fläche (210), eine erste laterale Seite (220) und eine zweite laterale Seite (230) aufweist,
wobei die erweiterte Leiterplatte (200) auf der Hauptleiterplatte (100) angeordnet ist, wobei die erste laterale Seite (220) und die zweite laterale Seite (230) der erweiterten Leiterplatte (200), welche einander gegenüberliegend sind, eine Vielzahl von ersten elektrischen Kontakten (250) beziehungsweise mindestens einen zweiten elektrischen Kontakt (260) aufweisen, und wobei die ersten Tanschlüsse (300) und der mindestens eine zweite Anschluss (400) in die Hauptleiterplatte (100) gesteckt sind, wobei die ersten Anschlüsse (300) sich krümmen und einen ersten Begrenzungsbereich (310) und einen ersten Kontaktbereich (320) bilden, wobei der mindestens eine zweite Anschluss (400) sich krümmt und einen zweiten Begrenzungsbereich (410) und einen zweiten Kontaktbereich (420) bildet, wobei ein Ende eines jeden ersten Begrenzungsbereichs (310) und ein Ende des zweiten Begrenzungsbereichs (410) in die Hauptleiterplatte (100) gesteckt sind, während die erweiterte Leiterplatte (200) zwischen den anderen Enden des ersten Begrenzungsbereichs (310) und dem anderen Ende des zweiten Begrenzungsbereichs (410), welche in elektrischem Kontakt mit den ersten elektrischen Kontakten (250) beziehungsweise dem zweiten elektrischen Kontakt (260) stehen, angeordnet ist, und wobei mindestens ein Teil des zweiten Kontaktbereichs (420) sich in Richtung der ersten lateralen Seite der erweiterten Leiterplatte erstreckt und gegen die obere Fläche (210) der erweiterten Leiterplatte (200) gepresst ist, wodurch die erweiterte Leiterplatte (200) an der Hauptleiterplatte (100) fixiert ist und die erweiterte Leiterplatte (200) und die Hauptleiterplatte (100) elektrisch miteinander kontaktieren, wobei die Summe der Anzahl der ersten elektrischen Kontakte (250) und der Anzahl des mindestens einen zweiten elektrischen Kontakts (260) acht beträgt, wobei die Summe der Anzahl der ersten Anschlüsse (300) und der Anzahl des mindestens einen zweiten Anschlusses (400) acht beträgt, wobei die erste laterale Seite (220) der erweiterten Leiterplatte (200) mindestens eine erste Aussparung (221) aufweist, wobei die zweite laterale Seite (230) mindestens eine zweite Aussparung (231) aufweist, wobei jeder erste elektrische Kontakt (250) an einer der mindestens einen ersten Aussparung (221) ausgebildet ist, und wobei jeder zweite elektrische Kontakt (260) in einer der mindestens einen zweiten Aussparung (231) ausgebildet ist.

2. Verbinder (1) nach Anspruch 1, bei dem die Anzahl der ersten elektrischen Kontakte (250) sechs beträgt, wobei die Anzahl des mindestens einen zweiten elektrischen Kontakts (260) zwei beträgt, wobei die Anzahl der ersten Anschlüsse (300) sechs beträgt, wobei die Anzahl des mindestens einen zweiten Abschlusses (400) zwei beträgt, wobei die ersten Anschlüsse (300) in einer ersten Linie angeordnet sind, wobei die zwei zweiten Anschlüsse (400) in einer zweiten Linie angeordnet sind, und wobei die ersten Linie und die zweite Linie zueinander parallel sind.

3. Verbinder (1) nach Anspruch 2, bei dem die zwei zweiten Anschlüsse (400) zueinander benachbart sind.

4. Verbinder (1) nach Anspruch 2, bei dem einer der ersten Anschlüsse (300) zwischen den zwei zweiten Anschlüsse (400) angeordnet ist.

5. Verbinder (1) nach Anspruch 2, bei dem zwei der ersten Anschlüsse (300) zwischen den zwei zweiten Anschlüssen (400) angeordnet sind,

6. Verbinder (1) nach Anspruch 1, bei dem die Hauptleiterplatte (100) eine Oberfläche (110) und einen Übertragungsschaltkreis (120) aufweist, wobei die erweiterte Leiterplatte (200) auf der Oberfläche (110) angeordnet ist, wobei die erweiterte Leiterplatte (200) einen erweiterten Schaltkreis (240) aufweist, wobei der Übertragungsschaltkreis (120) über die ersten Anschlüsse (300), den mindestens einen zweiten Anschluss (400), die ersten elektrischen Kontakte (250) und den zweiten elektrischen Kontakt (260) mit dem erweiterten Schaltkreis (240) elektrisch verbunden ist.

7. Verbinder (1) nach Anspruch 6, bei dem die Übertragungsanordnung (20) ferner eine Vielzahl von Steckanschlüssen (500) aufweist, und wobei die Steckanschlüsse (500) in die Hauptleiterplatte (100) gesteckt und mit dem Übertragungsschaltkreis (120) elektrisch verbunden sind.

8. Verbinder (1) gemäß Anspruch 1, bei dem das Isollergehäuse (10) umfasst:
einen Hauptkörper (12) mit einer Aufnahmenut (12b), wobei der Schlitz (12a) mit der Aufnahmenut (12b) verbunden ist, während die Übertragungsanordnung (20) in der Aufnahmenut (12b) angeordnet ist, und wobei der Schlitz (12a) die ersten Anschlüsse (300) und die zweiten Anschlüsse (400) freilegt,
eine obere Abdeckung (14), die auf dem Hauptkörper (12) angeordnet ist und die Übertragungsanordnung (20) abdeckt,
und eine hintere Abdeckung (16), die auf dem Hauptkörper (12) angeordnet ist, während die hintere Abdeckung (16) und der Hauptkörper (12) gemeinsam an zwei gegenüberliegende Seiten der Hauptleiterplatte (100) angrenzen.

9. Anordnungsverfahren für eine Übertragungsanordnung (20) eines Verbinders (1), das die folgenden Schritte umfasst:
Einstecken einer Vielzahl von ersten Anschlüssen (300) in eine Hauptleiterplatte (100);
Einstecken von mindestens einem zweiten Anschluss (400) in die Hauptleiterplatte (100);
**gekennzeichnet durch**:
Anordnen einer erweiterten Leiterplatte (200) auf der Hauptleiterplatte (100),
wobei eine erste laterale Seite (220) und eine zweite laterale Seite (230) der erweiterten Leiterplatte (200), welche einander gegenüber liegen, eine Vielzahl von ersten elektrischen Kontakten (250) beziehungsweise mindestens einen zweiten elektrischen Kontakt (260) aufweisen, wobei die erweiterte Leiterplatte (200) zwischen den ersten Anschlüssen (300) und dem zweiten Anschluss (400) angeordnet ist, wobei die erste laterale Seite (220) der erweiterten Leiterplatte (200) mindestens eine ersten Aussparung (221) aufweist, wobei die zweite laterale Seite (230) mindestens eine zweite Aussparung (231) aufweist, wobei die ersten elektrischen Kontakte (250) an der mindestens einen ersten Aussparung (221) ausgebildet sind, und wobei die zweiten elektrischen Kontakte (260) an der mindestens einen zweiten Aussparung (231) ausgebildet sind,
Biegen der ersten Anschlüsse (300), sodass die ersten Anschlüsse (300) jeweils einen ersten Begrenzungsbereich (310) und einen ersten Kontaktbereich (320) bilden, wobei die ersten Begrenzungsbereiche (310) jeweils mit den ersten elektrischen Kontakten (250) elektrisch kontaktiert sind, und wobei die ersten Kontaktbereiche (320) sich in Richtung der zweiten lateralen Seite (230) erstreecken, und
Biegen des zweiten Anschlusses (400), sodass dieser einen zweiten Begrenzungsbereich (410) und einen zweiten Kontaktbereich (120) bildet, wobei der zweite Begrenzungsbereich (410) elektrisch mit dem zweiten elektrischen Kontakt (260) kontaktiert ist, während der zweite Kontaktbereich (420) sich in Richtung der ersten lateralen Seite (220) erstreckt und gegen eine Seite der erweiterten Leiterplatte (200) entfernt von der Hauptleiterplatte (100) gepresst ist.

## Revendications

1. Connecteur (1) comprenant :
un logement isolé (10) présentant une fente (12a) ; et
un ensemble de transmission (20) situé dans le logement isolé (10), dans lequel l'ensemble de transmission (20) comprend une carte de circuit imprimé principal (100), une carte de circuit imprimé développé (200), une pluralité de premiers terminaux (300) et au moins un second terminal (400), la carte de circuit imprimé développé (200) a une surface supérieure (210), un premier côté latéral (220) et un second côté latéral (230), dans lequel la carte de circuit imprimé développé (200) est agencée sur la carte de circuit imprimé principal (100) et le premier côté latéral (220) et le second côté latéral (230) de la carte de circuit imprimé développé (200) qui sont en regard l'un de l'autre, ont une pluralité de premiers contacts électriques (250) et au moins un second contact électrique (260) respectivement, et les premiers terminaux (300) et l'au moins un second terminal (400) sont branchés dans la carte de circuit imprimé principal (100), dans lequel les premiers terminaux (300) plient et forment une première section limite (310) et une première section de contact (320), l'au moins un second terminal (400) plie et
forme une seconde section limite (410) et une seconde section de contact (420), une extrémité, de chaque première section limite (310) et une extrémité de la seconde section limite (410) sont branchées dans la carte de circuit imprimé principal (100) alors que la carte de circuit imprimé développé (200) est agencée entre les autres extrémités de la première section limite (310) et l'autre extrémité de la seconde section limite (410) qui sont en contact électrique avec les premiers contacts électriques (250) et le second contact électrique (260) respectivement et dans lequel au moins une partie de la seconde section de contact (420) s'étend vers le premier côté latéral de la carte de circuit imprimé développé et est pressée contre la surface supérieure (210) de la carte de circuit imprimé développé (200), fixant par là même la carte de circuit imprimé développé (200) à la carte de circuit imprimé principal (100) et amenant la carte de circuit imprimé développé (200) et la carte de circuit imprimé principal (100) à être reliées électriquement l'une à l'autre, dans lequel la somme des nombres des premiers contacts électriques (250) et du nombre de l'au moins un second contact électrique (260) est de huit, la somme du nombre des premiers terminaux (300) et du nombre de l'au moins un second terminal (400) est de huit, le premier côté latéral (220) de la carte de circuit imprimé développé (200) a au moins une première partie évidée (221), le second côté latéral (230) a au moins une seconde partie évidée (231), chaque premier contact électrique (250) est formé sur une au moins une première partie évidée (221) et chaque second contact électrique (260) est formé sur une au moins une seconde partie évidée (231).

2. Connecteur selon la revendication 1, dans lequel le nombre de premiers contacts électriques (250) est de six, le nombre de l'au moins un second contact électrique (260) est de deux, le nombre des premiers terminaux (300) est de six, le nombre de l'au moins un second terminal (400) est de deux, les premiers terminaux (300) sont agencés dans une première ligne, les deux seconds terminaux (400) sont agencés dans une seconde ligne, et la première ligne et la seconde ligne sont parallèles l'une à l'autre.

3. Connecteur (1) selon la revendication 2, dans lequel les deux seconds terminaux (400) sont adjacents l'un à l'autre.

4. Connecteur (1) selon la revendication 2, dans lequel un des premiers terminaux (300) est entre les deux seconds terminaux (400).

5. Connecteur (1) selon la revendication 2, dans lequel deux des premiers terminaux (300) sont entre les deux seconds terminaux (400).

6. Connecteur (1) selon la revendication 1, dans lequel la carte de circuit imprimé principal (100) a une surface (110) et un circuit de transmission (120), la carte de circuit imprimé développé (200) est agencée sur la surface (110), la carte de circuit imprimé développé (200) a un circuit développé (240), le circuit de transmission (120) est relié électriquement au circuit développé (240) via les premiers terminaux (300), l'au moins un second terminal (400), les premiers contacts électriques (250) et le second contact électrique (260).

7. Connecteur (1) selon la revendication 6, dans lequel l'ensemble de transmission (20) comprend en outre une pluralité de terminaux de perçage (500), et les terminaux de perçage (500) sont branchés dans la carte de circuit imprimé principal (100) et sont reliés électriquement au circuit de transmission (120).

8. Connecteur (1) selon la revendication 1, dans lequel le logement isolé (10) comprend :
un corps principal (12) présentant une encoche de logement (12b), la fente (12a) reliant l'encoche de logement (12b) alors que l'ensemble de transmission (20) est situé dans l'encoche de logement (12b) et la fente (12a) expose les premiers terminaux (300) et le second terminal (400) ;
un couvercle supérieur (14) installé sur le corps principal (12) et couvrant l'ensemble de transmission (20) ;
et un couvercle arrière (16) installé sur le corps principal (12) alors que le couvercle arrière (16) et le corps principal (12) butent ensemble contre deux côtés en regard de la carte de circuit imprimé principal (100).

9. Procédé d'assemblage pour un ensemble de transmission (20) d'un connecteur (1), comprenant les étapes de :
branchement d'une pluralité de premiers terminaux (300) dans une carte de circuit imprimé principal (100) ;
branchement au moins d'un second terrrairlal (400) dans la carte de circuit imprimé principal (100), **caractérisé par**
l'agencement d'une carte de circuit imprimé développé (200) sur la carte de circuit imprimé principal (100) dans lequel un premier côté latéral (220) et un second côté latéral (230) de la carte de circuit imprimé développé (200) qui sont en regard l'un de l'autre ont une pluralité de premiers contacts électriques (250) et au moins un second contact électrique (260) respectivement, la carte de circuit imprimé développé (200) est agencée entre les premiers terminaux (300) et le second terminal (400), le premier côté latéral (220) de la carte de circuit imprimé développé (200) a au moins une première partie évidée (221), le second côté latéral (230) a au moins une seconde partie évidée (231), les premiers contacts électriques (250) sont formés sur l'au moins une première partie évidée (221), et les seconds contacts électriques (260) sont formés sur l'au moins une seconde partie évidée (231) ; le pliage des premiers terminaux (300) de sorte que les premiers terminaux (300) forment chacun une première section limite (310) et une première section de contact (320), dans lequel les premières sections limites (310) sont en contact électrique avec les premiers contacts électriques (250) respectivement, et les première sections de contact (320) s'étendent vers le second côté latéral (230) ;
et
le pliage du second terminal (400) de sorte qu'il forme une seconde section limite (410) et une seconde section de contact (420), dans lequel la seconde section limite (410) est en contact électrique avec le second contact électrique (260) alors que la seconde section de contact (420) s'étend vers le premier côté latéral (220) et est pressée contre un côté de la carte de circuit imprimé développé (200) loin de la carte de circuit imprimé principal (100).
